# EUROPEAN PATENT APPLICATION

(11) **EP 2 180 598 A1**
(43) Date of publication of application: **28.04.2010**
(21) Application number: 08291004.3
(22) Date of filing: 24.10.2008
(51) Int. Cl.: H03K 17/082

(54) **Circuit and method for determining inductance of an integrated power converter**

(71) Applicant: NXP B.V., 5656 AG Eindhoven (NL)
(72) Inventor: The designation of the inventor has not yet been filed
(74) Representative: Hardingham, Christopher Mark

(57) **Abstract**

An integrated circuit, e.g. a boost converter (1), and method of operating the same, the integrated circuit comprising: an inductor (3), means for determining an estimate of the inductance of the integrated circuit (11), and means for switching off the integrated circuit if the determined estimate of inductance exceeds a threshold. The integrated circuit may comprise a peak current comparator (6) arranged to measure a peak current in the integrated circuit. The integrated circuit may comprise a timer (10) arranged to operate the peak current comparator (6) for a fixed amount of time. The integrated circuit may comprise means for fixing a peak current in the integrated circuit and measuring the time taken to reach the given fixed peak current.

## Description

The present invention relates to integrated circuits comprising at least one inductor.

Inductors in integrated circuits can become damaged. For example, when a mobile phone is dropped, the magnetic core of an inductor of an integrated circuit contained within the mobile phone may break. This will result in a lower inductance and a higher peak current in the integrated circuit. This may cause overheating of the integrated circuit or its battery. Examples of integrated circuits comprising inductors include a boost (up) converter, a buck (down) converter, and a fly back (buck-boost) converter.
Figure 1 is a schematic circuit diagram of a typical known boost converter.
Figure 2 is a schematic circuit diagram of a typical known buck converter.
Figure 3 is a schematic circuit diagram of a typical known buck-boost converter.

The present inventors have realised it would be desirable to provide an integrated circuit that switches off when inductance is too low or the peak current is too high.

The present inventors have also realised it would be desirable to provide an integrated circuit that facilitates the measurement of the inductance and/or the peak current in the integrated circuit.

In a first aspect, the present invention provides a method of operating an integrated circuit, the method comprising the steps of determining an estimate of the inductance of the integrated circuit, and switching off the integrated circuit if the determined estimate of inductance exceeds a threshold value.

The step of determining an estimate of the inductance of the integrated circuit may comprise measuring a peak current in the integrated circuit.

The step of determining an estimate of the inductance on the integrated circuit may further comprise measuring a peak current in the integrated circuit for a fixed amount of time.

The fixed amount of time may be determined by a one-shot timer.

A constant time may be added to the fixed amount of time.

The step of determining an estimate of the inductance of the integrated circuit may comprise fixing a peak current in the integrated circuit and measuring the time taken to reach the given fixed peak current.

The integrated circuit may be one of a boost converter, a buck converter, or a buck-boost converter.

In a further aspect, the present invention provides an integrated circuit comprising an inductor, means for determining an estimate of the inductance of the integrated circuit, and means for switching off the integrated circuit if the determined estimate of inductance exceeds a threshold value.

The means for determining an estimate of the inductance of the integrated circuit may comprise a peak current comparator arranged to measures a peak current in the integrated circuit.

The means for determining an estimate of the inductance of the integrated circuit may comprise a timer, and the timer may operate the peak current comparator for a fixed amount of time.

The timer may be a one shot timer.

A constant time may be added to the fixed amount of time.

The means for determining an estimate of the inductance of the integrated circuit may comprise means for fixing a peak current in the integrated circuit and measuring the time taken to reach the given fixed peak current.

The integrated circuit may be one of a boost converter, a buck converter, or a buck-boost converter.

Embodiments of the present invention will now be described, by way of example, with reference to the accompanying drawings, in which:

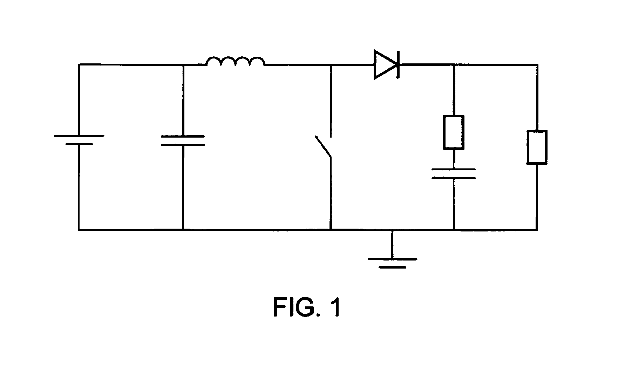

Figure 1 is a schematic circuit diagram of a typical known boost converter;

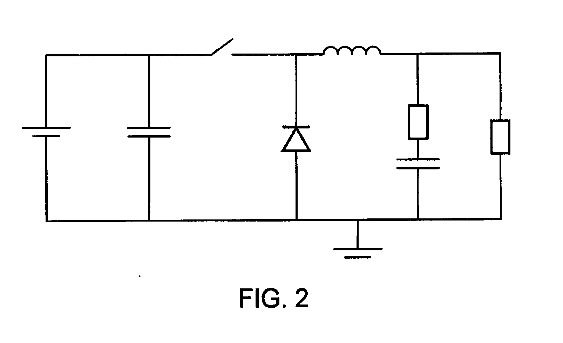

Figure 2 is a schematic circuit diagram of a typical known buck converter;

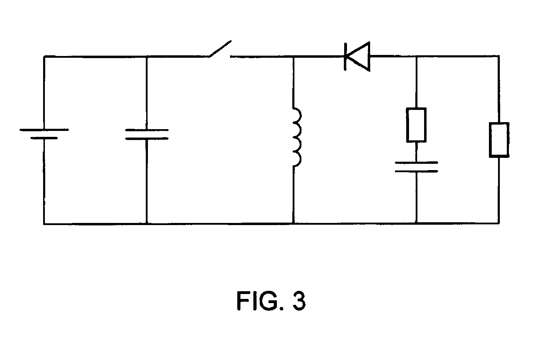

Figure 3 is a schematic circuit diagram of a typical known buck-boost converter;

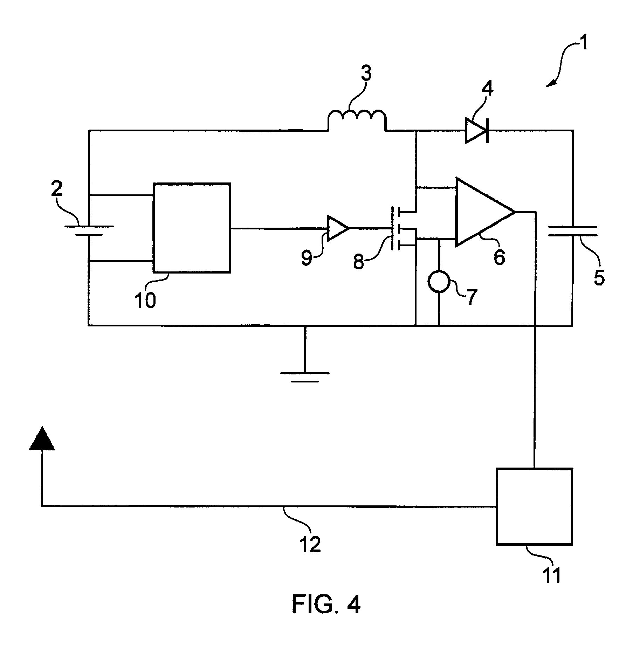

Figure 4 is a schematic circuit diagram of an embodiment implemented in a boost converter;

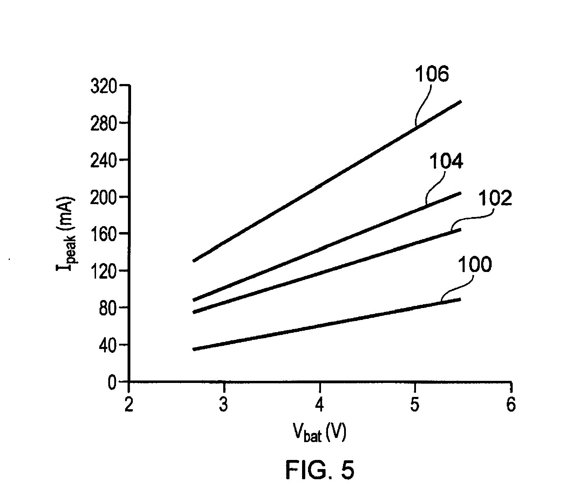

Figure 5 is a graph showing the measured peak currents for boost converters comprising inductors having various inductance values;

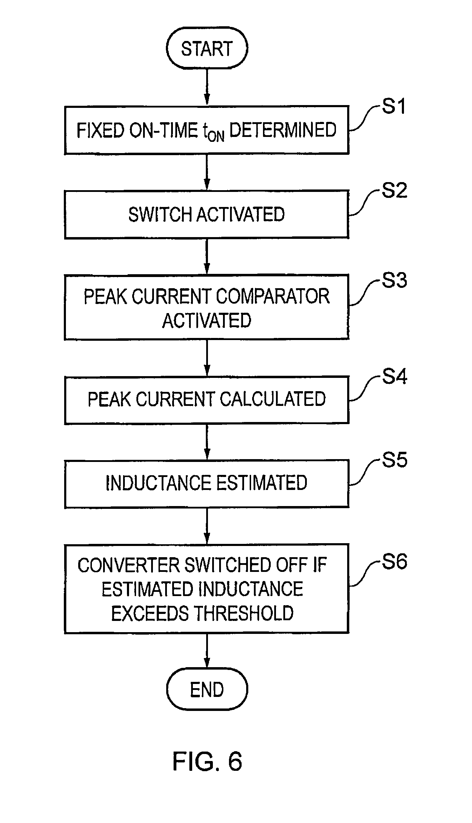

Figure 6 is a flow chart showing certain steps that are carried out when operating the boost converter of Figure 4;

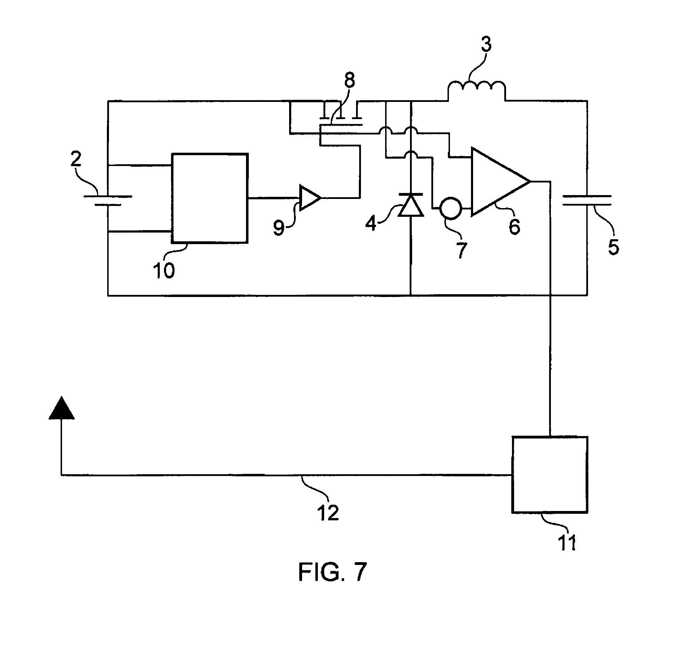

Figure 7 is a schematic circuit diagram of an embodiment implemented in a buck converter;

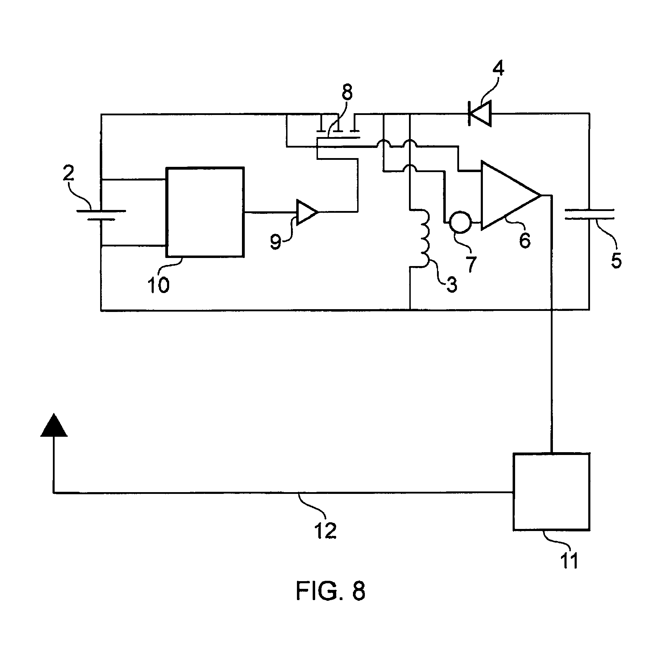

Figure 8 is a schematic circuit diagram of an embodiment implemented in a buck-boost converter;

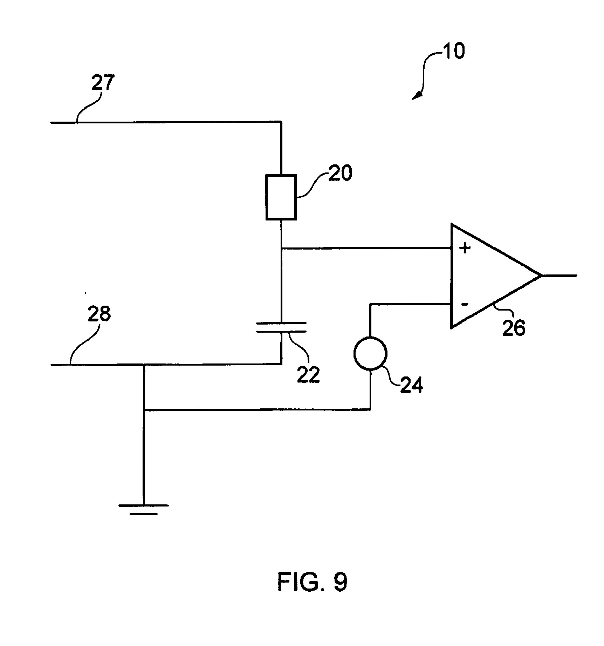

Figure 9 is a schematic circuit diagram of one embodiment of a timer;

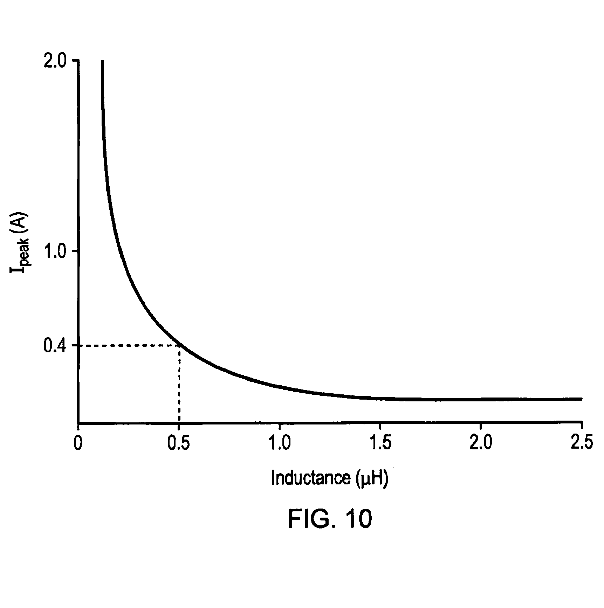

Figure 10 is a graph showing the peak current as a function of the inductance of the inductor;

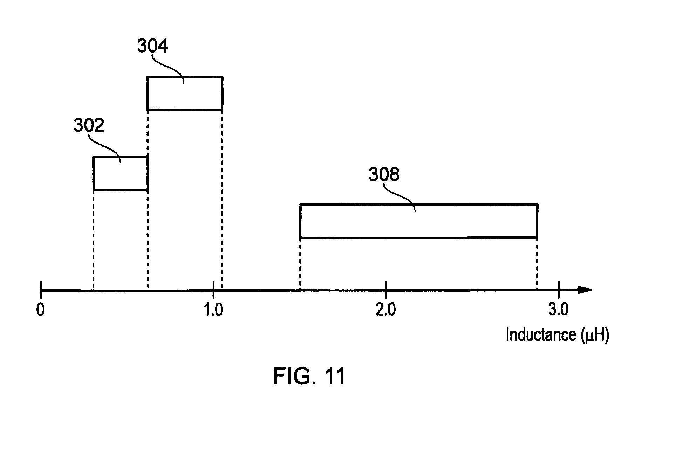

Figure 11 is a schematic illustration depicting example classification states of boost converters depending on measured inductance values; and

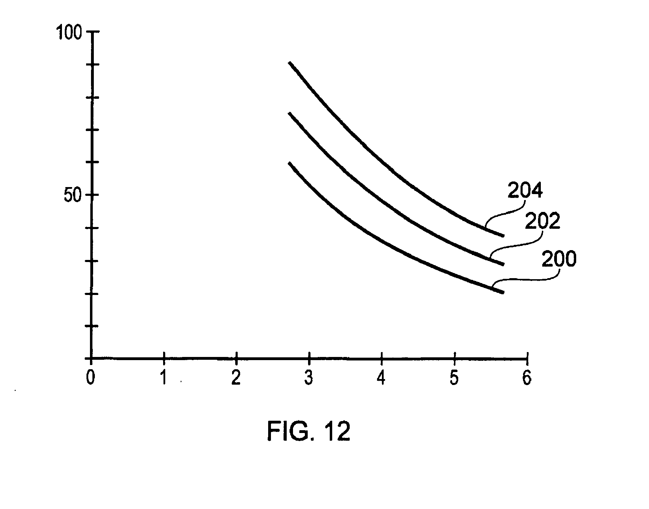

Figure 12 shows the relationship between the on-time and the battery voltage for a fixed peak current for boost converters with various inductance values.
Figure 4 is a schematic circuit diagram of an embodiment of an integrated circuit, more particularly a boost converter 1. The boost converter 1 comprises a battery 2, an inductor 3, a peak current comparator 6, a diode 4, a DC load 5, a timer 10, a voltage supply 7, a switch 8, an amplifier 9 and a logic unit 11.

The battery 2 provides a voltage on the boost converter 1.

The inductor 3 is connected to the battery 2. The inductor 3 comprises a magnetic core.

The peak current comparator 6 is connected to voltage supply 7. The peak current comparator 6 is operated by switch 8. The peak current comparator 6 is used to measure the peak current in the boost converter 1. The peak current comparator 6 sends a signal indicative of peak current in the boost converter 1 to the logic unit 11.

The diode 4 is connected to the battery 2 via the inductor 3.

The current output 5 is connected to the battery 2 via the diode 4 and the inductor 3.

The timer 10 is a one-shot timer. The timer 10 comprises a power supply input and an output. The power supply inputs of the timer 10 are connected to the battery 2. The output of the timer 10 is connected to the switch 8 via the amplifier 9.

The DC load 5 is the load driven by the battery 2 and provides to current output.

The switch 8 is connected to the output of the timer 10 via the amplifier 9. The switch 8 is operated by the amplified output signal from the timer 10. The switch 8 has two operating positions, an on-state and an off-state. The operating positions of the switch 8 are dependent on the output from the timer 10. The switch 8 operates the peak current comparator 6.

The logic unit 11 receives a signal indicative of peak current in the boost converter 1 from the peak current comparator 6. The logic unit 11 estimates the inductance on the boost converter 1. If the estimated inductance exceeds a predetermined threshold of 0.6µH, the logic unit 11 transmits a control signal 12.

The control signal 12 turns the boost converter 1 off.

Thus, in this embodiment a boost converter 1 comprising a peak current comparator 6 operated by a timer controlled switch 8 is provided. An advantage of the peak current comparator 6 operated by a timer controlled switch 8 is that it facilitates the estimation of the value of the inductance in the boost converter 1. The value of the inductance on the boost converter 1 is indicative of whether or not the inductor 2 in the boost converter 1 is broken.

The inductance on the boost converter 1 is estimated by fixing the amount of time (tₒₙ) that the switch 8 activates the peak current comparator 6 for, and measuring the peak current (lₚₑₐₖ) in the boost converter 1 during that time. The fixed amount of time (tₒₙ) that the switch 8 activates the peak current comparator 6 is 32.5ns. The measured peak current (lₚₑₐₖ) is dependent on the voltage of the battery (V_{bat}).

Figure 5 shows the measured peak currents for boost converters with inductors having inductance values of 2.2µH 100, 1.0 µH 102, 0.8 µH 104 and 0.6 µH 106, for battery voltages of between 2V and 6V. In this embodiment, a boost converter 1 with an inductor 3 having an inductance value of 2.2µH 100 is a correctly working boost converter. The detection threshold for a broken inductor is 0.6µH 106. Any boost converter that is determined to have an inductor with an inductance value of less than 0.6µH is considered to contain a broken inductor and is switched off.

Figure 6 is a flow chart showing certain steps that are carried out when operating the above described boost converter 1. At step s1 a fixed on-time for the timer 10 is determined. This fixed on-time is e.g. 31.25ns (1/16 of a cycle). At step s2 the switch 8 is activated for the fixed on-time. At step s3 the peak current comparator 6 is activated for the fixed on-time. At step s4 the peak current during the fixed on-time is calculated. At step s5 the value of the inductance on the boost converter 1 is estimated from the measured peak current. At step s6, if the estimated inductance exceeds a predetermined threshold of 0.6µH, the boost converter 1 is switched off. If the estimated inductance does not exceed 0.6µH, the boost converter 1 is not switched off.

The above embodiment is implemented as a boost converter 1. However, in other embodiments the invention may be incorporated into other integrated circuits, such other DC-DC converters, for example a buck converter or a buck-boost converter.

Figure 7 is a schematic circuit diagram of an embodiment implemented in a buck converter. The same reference numerals as those employed in Figure 4 have been used to indicate the same elements.

Figure 8 is a schematic circuit diagram of an embodiment implemented in a buck-boost converter. The same reference numerals as those employed in Figure 4 have been used to indicate the same elements.

In the above embodiments the timer 10 is a one-shot timer. Figure 9 is a schematic circuit diagram of one embodiment of a timer 10, comprising a resistor 20, a capacitor 22, a voltage supply 24, a comparator 26, a first connector 27, and a second connector 28. The first connector 27 and the second connector 28 connect to the connections either side of the battery 2 shown in Figure 4. In other embodiments, other timers may be used.

In the above embodiments there was no addition of a constant time to the fixed amount of time (tₒₙ) that the switch 8 activates the peak current comparator 6. However, in other embodiments a constant time is added to the fixed on-time (tₒₙ) in order to compensate for a delay in the peak current comparator. This constant time can be added, for example, by incorporating a fixed delay in the timer.

In the above embodiments, the fixed amount of time (tₒₙ) that the switch 8 activates the peak current comparator 6 is 31.25 ns. However, in other embodiments, other fixed on-times can be used. Also, the fixed on-time can be chosen such that the peak current (lₚₑₐₖ) is a certain value for a given value of the inductance of the inductor 2, for example, the fixed on-time could be chosen such that the peak current (lₚₑₐₖ) is 0.4A for an inductor of inductance 0.5µH.

Figure 10 is a graph showing the peak current (lₚₑₐₖ) as a function of the inductance of the inductor. In one embodiment of the invention, the boost converter 1 is considered to comprise a broken inductor and is turned off if the peak current is more than 0.4A, although other values for the peak current could be used.

In the above embodiments, the detection threshold for a broken inductor is 0.6µH. However, in other embodiments other detection thresholds for a broken inductor can be used, for example 0.4µH, 0.5µH, 0.8µH, or 1.0µH. Figure 11 is a schematic illustration depicting example classification states of boost converters depending on measured inductance values. The example classification states depicted in Figure 11 are "Good inductor" 308 which covers the region 2.2µH ± 30%, "Ideal Detection Region" 304 which covers the region 0.8µH ± 0.2µH and "Bad Inductor" 302 which covers the region 0.3µH to 0.6µH.

In the above embodiments, inductance on the boost converter 1 is estimated by fixing the amount of time (tₒₙ) that the switch 8 activates the peak current comparator 6 for, and measuring the peak current (lₚₑₐₖ) in the boost converter 1 during that time. However, in other embodiments, other methods of estimating the inductance on the boost converter 1 can be used. For example, in other embodiments the inductance on the boost converter 1 is estimated by fixing the peak current (lₚₑₐₖ) in the boost converter and measuring the on-time (tₒₙ) taken to reach the given fixed peak current. Figure 12 shows the relationship between the on-time (ton) and the battery voltage (V_{bat}) for a fixed peak current of 0.4A for a boost converters with inductance values of 0.4µH 200, 0.5µH 202, and 0.6µH 204. In other embodiments, different values for the fixed peak current (lₚₑₐₖ) can be used.

It will be appreciated in the above embodiments that the provided integrated circuits facilitate the avoidance of battery or integrated circuit overheating by providing means to switch off the device if the inductance in the circuit becomes too high.

## Claims

1. A method of operating an integrated circuit (1), the method comprising the steps of:
determining an estimate of the inductance of the integrated circuit (1); and;
switching off the integrated circuit (1) if the determined estimate of inductance exceeds a threshold value.

2. A method of operating an integrated circuit (1) according to claim 1, wherein the step of determining an estimate of the inductance of the integrated circuit comprises measuring a peak current in the integrated circuit.

3. A method of operating an integrated circuit (1) according to claim 2, wherein the step of determining an estimate of the inductance of the integrated circuit further comprises measuring a peak current in the integrated circuit for a fixed amount of time.

4. A method of operating an integrated circuit (1) according to claim 3 wherein the fixed amount of time is determined by a one-shot timer (10).

5. A method of operating an integrated circuit (1) according to claims 3 or 4 wherein a constant time is added to the fixed amount of time.

6. A method of operating an integrated circuit (1) according to claim 1, wherein the step of determining an estimate of the inductance of the integrated circuit comprises fixing a peak current in the integrated circuit and measuring the time taken to reach the given fixed peak current.

7. A method of operating an integrated circuit (1) according to any of the above claims, wherein the integrated circuit is one of a boost converter, a buck converter, or a buck-boost converter.

8. An integrated circuit (1) comprising:
an inductor (3);
means for determining an estimate of the inductance of the integrated circuit (11); and
means for switching off the integrated circuit if the determined estimate of inductance exceeds a threshold value.

9. An integrated circuit (1) according to claim 8, wherein the means for determining an estimate of the inductance of the integrated circuit (11) comprises a peak current comparator (6) arranged to measure a peak current in the integrated circuit.

10. An integrated circuit (1) according to claim 9, wherein the means for determining an estimate of the inductance of the integrated circuit (11) further comprises:
a timer (10); and
the timer (10) operates the peak current comparator (6) for a fixed amount of time.

11. An integrated circuit (1) according to claim 10, wherein the timer (10) is a one shot timer.

12. An integrated circuit (1) according to claim 10 or 11, wherein a constant time is added to the fixed amount of time.

13. An integrated circuit (1) according to claims 8, wherein the means for determining an estimate of the inductance of the integrated circuit comprises means for fixing a peak current in the integrated circuit and measuring the time taken to reach the given fixed peak current.

14. An integrated circuit (1) according to any of the claims 8-13, wherein the integrated circuit is one of a boost converter, a buck converter, or a buck-boost converter.
